# EUROPÄISCHE PATENTANMELDUNG

(11) **EP 3 578 996 A1**
(43) Veröffentlichungstag der Anmeldung: **11.12.2019**
(21) Anmeldenummer: 19177560.0
(22) Anmeldetag: 31.05.2019
(51) Int. Cl.: G01R 1/067, G01R 19/155, G01R 19/165

(54) **SPANNUNGSPRÜFGERÄT**

(30) Priorität: 30.05.2018 DE 202018103059 U
(71) Anmelder: Testboy GmbH, 49377 Vechta (DE)
(72) Erfinder: Mpouras, Evangelos, 49377 Vechta (DE)
(74) Vertreter: Eisenführ Speiser

(57) **Zusammenfassung**

Die Erfindung betrifft eine Prüfeinrichtung, welche ähnlich wie ein Stift gehalten wird, wobei die Prüfeinrichtung ein längliches Gehäuse aufweist, mit einem ersten Ende und einem zweiten Ende, wobei zur Spannungsprüfung das erste Ende an einen spannungsführenden Leiter gehalten, oder in dessen Nähe gebracht wird und wobei das zweite Ende dem ersten Ende gegenüberliegt und außenseitig eine Aufnahme für ein von außen in die Aufnahme steckbares Werkzeug aufweist, wobei die Aufnahme Standard-Innen-Abmaße für die Aufnahme eines Standart-Werkzeuges aufweist und wobei die Prüfeinrichtung ein Gehäuse aus elektrisch isolierendem Material aufweist.

## Beschreibung

Die Erfindung betrifft ein Spannungsprüfgerät.

Solche Spannungsprüfgeräte sind in vielfacher Form bekannt und unterscheiden sich im Wesentlichen durch die Ausbildung als Prüfgeräte, die die zu prüfende Spannung entweder kontaktlos messen, oder kontaktbehaftet messen.

Bei der kontaktbehafteten Messung weist das Spannungsprüfgerät eine Messspitze (Klinge) auf, welche an einen spannungsführenden Leiter gehalten wird.

Auch kontaktlose Spannungsprüfgeräte sind bereits bekannt. Hierbei ist eine Spannungsprüfelektronik in dem Spannungsprüfgerät untergebracht und auch hierbei weist das Spannungsprüfgerät eine Art Messspitze auf, welche allerdings nach außen hin elektrisch isoliert ist und zur Erfassung der Spannung nur bis auf einen vorbestimmten Abstand z. B. 10 - 30mm an einen spannungsführenden Leiter, z. B. ein Stromkabel, gehalten werden muss.

Regelmäßig sind solche Spannungsprüfgeräte auch auf bestimmte Schwellspannungen ausgelegt.

Das bedeutet, dass erst dann, wenn eine bestimmte Schwellspannung überschritten wird, dies auch dem Benutzer eine vorab festgelegte Information angezeigt wird, sei es durch Aufleuchten eines Lichtes und/oder einer Vibration und/oder auch einem akustischen Ton, oder dergleichen.

Bekannte kontaktlose Spannungsprüfgeräte weisen auch oftmals zwei Schwellen auf, d. h., dass eine erste Schwelle von z. B. 12 Volt und eine zweite Spannungsschwelle von etwa 110 Volt geprüft wird und mittels eines Umschalters ist die gewünschte Schwelle auswählbar ist, sodass dann, wenn die ausgewählte Schwelle überschritten wird, das gewünschte voreingestellte Informationssignal (z. B. Licht, Ton, Vibration etc.) seitens des Spannungsprüfgerätes abgegeben wird.

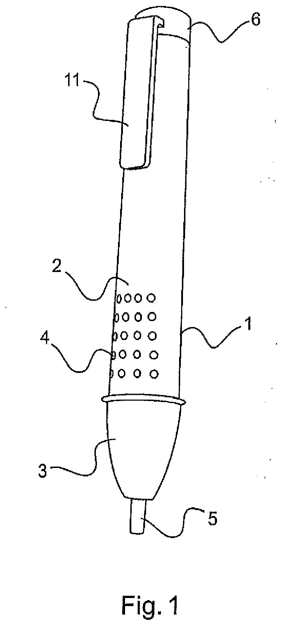

Ein bekanntes kontaktloses Spannungsprüfgerät ist in Figur 1 dargestellt.

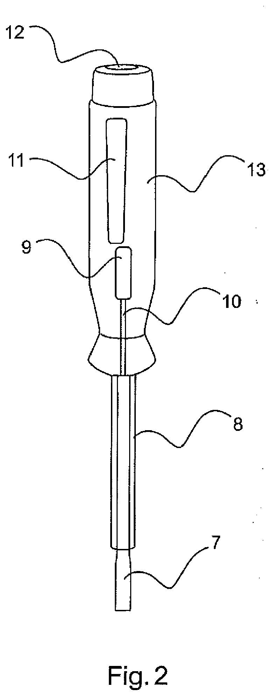

Ein bekannter kontaktbehafteter Spannungsprüfer in der Ausbildung als einpoliger Spannungsprüfer, ist in Figur 2 dargestellt. Solch ein Spannungsprüfer wird auch regelmäßig Phasenprüfer genannt und zeichnet sich dadurch aus, dass er einen, ähnlich einem Stift (Kugelschreiber) ausgebildeten Körper, aufweist, sodass der Benutzer den Spannungsprüfer wie einen Stift mit 2 oder 3 Fingern einer Hand halten kann, um die Spitze des kontaktbehafteten Spannungsprüfers an einen kontaktführenden Leiter zu halten, oder beim berührungslosen Spannungsprüfer, diesen in die Nähe des spannungsführenden Leiters zu halten.

Einpolige, kontaktbehaftete Spannungsprüfer sind regelmäßig nicht nur in stiftform ausgebildet, sondern auch in Form eines Schraubendrehers, wobei die Messspitze gleichzeitig als Schraubendreherspitze (z. B. für Schlitzschrauben) ausgebildet ist, sodass ein Gehäuse, z. B. das Gehäuse eines Schutzkontaktsteckers, mit dem Schraubendreher befestigt oder gelöst werden kann, um beispielsweise bei einem gelösten Schutzkontaktsteckergehäuse dann mittels der Messspitze auch zu prüfen, ob ein Fehler in der elektrischen Kontaktierung der Kontakte des Schutzkontaktsteckers (Schuko), vorliegt, oder die gewünschte Spannung z. B. 230V (oder mehr) am Kontakt anliegt.

Bei berührungslosen Spannungsprüfern ist die Messspitze in einem vorderen Teil des stiftartigen Gehäuses untergebracht und gänzlich, z. B. durch einen Kunststoff, nach außen isoliert. Die Messspitze ist dabei regelmäßig in Form eines Zylinders ausgebildet, also einer Spitze mit in etwa kreisrundem Querschnitt. Andere Querschnittsformen sind auch möglich, auch ist die Länge der Spitze variabel, z. B. zwischen 1 - 30 mm lang.

Wenn zum Einsatz eines berührungslosen Spannungsprüfers ein Gehäuse geöffnet werden muss, oder nach dem Einsatz des berührungslosen Spannungsprüfers das Gehäuse verschlossen werden muss, z. B. durch Lösen oder Festziehen von Schrauben, ist dazu ein separates Werkzeug notwendig, wie z. B. ein Schraubendreher, ein Schraubenschlüssel, Zange, Maulschlüssel oder dergleichen.

Die vorliegende Erfindung betrifft eine Prüfeinrichtung, insbesondere einen Spannungsprüfer, mit welchem es möglich ist, sowohl die gewünschte Größe zu prüfen, z. B. die elektrische Spannung, mit welcher es ferner auch möglich ist, Schrauben, Rastverbindungen oder dergleichen von einem Gehäuse einer elektrischen Einrichtung zu lösen und/oder zu befestigen, wobei das Werkzeug hierzu nicht gleichzeitig auch eine Messspitze darstellen soll.

Die Erfindung ist besonders bevorzugt einsetzbar für ein kontaktloses Spannungsprüfgerät, allerdings ist auch der Einsatz für ein kontaktbehaftetes Spannungsprüfgerät möglich und vorteilhaft.

Die erfindungsgemäße Prüfeinrichtung wird durch die Merkmale der Ansprüche 2 bis 5 vorteilhaft weitergebildet.

Die erfindungsgemäße Aufgabe wird mit einer Prüfeinrichtung mit den Merkmalen nach Anspruch 1 gelöst. Vorteilhafte Weiterbildungen sind in den Unteransprüchen beschrieben.
In Figur 1 ist die Ansicht eines bekannten kontaktlosen Spannungsprüfgerätes dargestellt.
Figur 2 zeigt die Ansicht eines bekannten kontaktbehafteten Spannungsprüfgeräts.
Figur 3 zeigt den Einsatz eines bekannten kontaktbehafteten Spannungsprüfgeräts.
Die Figuren 4a und 4b zeigen die verschiedenen Seitenansichten einer erfindungsgemäßen Prüfeinrichtung.
Figur 5 zeigt die perspektivische Ansicht des hinteren Seitenendes eines erfindungsgemäßen Prüfgerätes.
Figur 6 zeigt die perspektivische Ansicht eines erfindungsgemäßen Prüfgeräts mit eingesetztem Werkzeugbit.
Figur 7 zeigt eine erfindungsgemäße Prüfeinrichtung in verschiedenen Darstellungen und Ansichten.

Figur 1 zeigt die Seitenansicht eines bekannten kontaktlosen Spannungsprüfgeräts. Dieses ist ähnlich wie ein Stift aufgebaut und wird bei der Anwendung auch ähnlich wie ein Stift gehalten, z. B. zwischen dem Daumen und dem Zeigefinger oder zwischen Daumen, Zeigefinger und Mittelfinger.

Das Spannungsprüfgerät 1 weist somit ein längliches Gehäuse 2 auf, wobei das Gehäuse im dargestellten Beispiel nach Figur 1 aus zwei Teilen 3 und 4 besteht, die miteinander befestigt sind. Das dargestellte Spannungsprüfgerät weist ein erstes Ende 5 auf und ein dem ersten Ende gegenüberliegendes Ende 6.

Im Inneren des Gehäuses des Spannungsprüfgeräts ist eine elektrische Schaltung untergebracht, wie auch eine Aufnahme für eine Batterie zur elektrischen Versorgung der Schaltung.

Wird das Gerät mit seiner Messspitze, welche bevorzugt am ersten Ende 5 des Spannungsprüfgeräts innerhalb des Gehäuses untergebracht ist, nahe, z. B. 1 - 30 mm Abstand zu einem spannungsführenden Leiter gehalten, so wird dies dem Benutzer durch eine entsprechende Information, z. B. durch Vibrieren des Spannungsprüfgeräts in seiner Hand und/oder durch ein aufleuchtendes Licht (welches am zweiten Ende (in der Figur nicht dargestellt)) angebracht ist und/oder durch einen hörbar wahrnehmbaren Ton mitgeteilt.

Ein solches bekanntes Spannungsprüfgerät weist oftmals auch eine Schwellenumschaltung auf, das heißt, es ist an einem Gerät außenseitig ein Schalter bzw. Taster 18 vorhanden, mittels welchem voreingestellte Schwellen für bestimmte Spannungshöhen einstellbar bzw. umstellbar sind. Zum Beispiel weist das eingestellte kontaktlose Spannungsprüfgerät eine Schwelle für 12 Volt auf, wie auch für 110 Volt.

Wird beispielsweise die 12 Volt-Schwelle eingestellt, so wird dem Benutzer dann, wenn er das Spannungsprüfgerät mit seiner Messspitze nah genug an einen spannungsführenden Leiter hält, der 12 Volt oder mehr aufweist, entsprechend angezeigt.

Bei der Umstellung auf die Schwelle 110 Volt erfolgt die Anzeige nur dann, wenn der spannungsführende Leiter eine Spannung von mehr als 110 Volt aufweist.

Da im Haushalt üblicherweise nur 2 Spannungslevel üblich sind, nämlich 230 Volt und mehr für die normale Haushaltsspannungsversorgung und 12 Volt für Lichtsysteme im Niedervoltbereich, reicht die Ausgestaltung von zwei Spannungsschwellen aus, bei Bedarf kann auch eine weitere Schwellenaufteilung, z. B. eine dritte Schwelle 400 V, eingerichtet werden.

Figur 2 zeigt einen bekannten kontaktbehafteten Spannungsprüfer in Form eines einpoligen Phasenprüfers. Dieser weist an seinem ersten Ende eine Klinge 7 auf, welche aus Metall gefertigt ist und die Form eines Schlitzschraubendrehers hat.

Im Weiteren ist der Klingenhals mit einer Isolation 8 versehen, damit bei der Prüfung die Bedienperson nicht unabsichtlich einen Finger an das Metall des Klingenhalses halten kann.

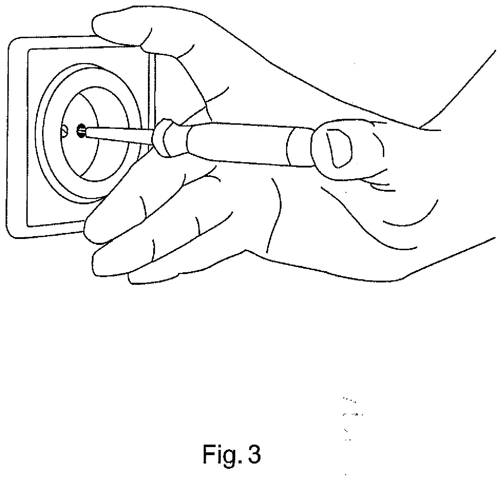

Darüber hinaus weist der Spannungsprüfer ein Gehäuse 13 auf, innerhalb dessen auch ein Widerstand 10 und eine Schaltung untergebracht ist, welche zum Aufleuchten der mit dem Widerstand verbundenen Glimmlampe 9 führt, wenn die Bedienperson das Spannungsprüfgerät mit seiner Klinge 7 kontaktierend an einen metallführenden Leiter hält und dabei gleichzeitig den am zweiten Ende des Spannungsprüfers ausgebildeten metallischen Kontakt 12 berührt (siehe hierzu auch Fig. 3).

Regelmäßig weisen solche Spannungsprüfer wie in Figur 1 und 2 dargestellt, auch einen Klipp 11 auf, mittels welchen solche Spannungsprüfer vom Bedienpersonal an der Kleidung, z. B. der Hemdtasche, gut befestigt werden können.

Wie erwähnt weist ein bekannter einpoliger Phasenprüfer regelmäßig an dem vorderen ersten Ende eine Klinge 7 auf, welche meistens nach Art eines Schlitz-Schraubendrehers ausgebildet ist.

Damit können zwar kleinere Schrauben gelöst oder befestigt werden, allerdings ist das Werkzeug hierfür ungeeignet, wenn die Schraube in der Art eines TORX oder Inbus oder dergleichen ausgebildet ist, oder beim Lösen der Schraube eine größere Kraft aufgebracht werden muss, weil entweder die Schraube relativ groß ist, oder andererseits auch relativ festsitzt.

Mittels des in Figur 2 dargestellten Spannungsprüfers ist deshalb das Lösen einer Schraube auch oft überhaupt nicht möglich.

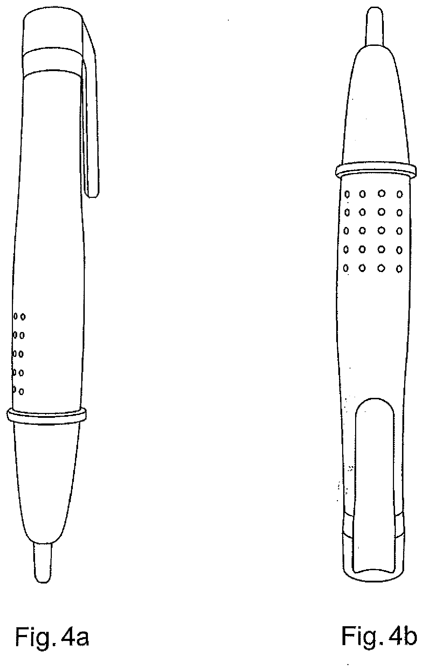

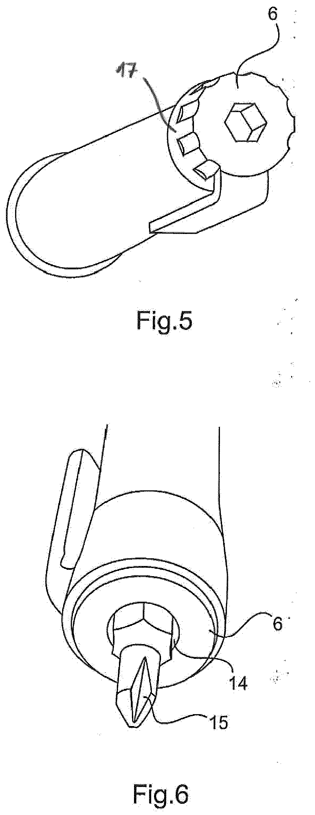

Die Figuren 4a und 4b zeigen in der Außenansicht die erfindungsgemäßen Spannungsprüfer, wobei das besondere des zweiten Endes 6 des Spannungsprüfers in Figur 5 deutlich wird.

Figur 5 zeigt in der perspektivischen Ansicht das zweite Ende 6 des Spannungsprüfers, und dort ist gut eine sechseckige (Hexabit) Aufnahme 14 für ein Standart-Werkzeug(bit) 15 zu erkennen.

Da solche Standart-Bits überall vorhanden sind, insbesondere auch in jedem Werkzeugkasten und diese Bits ein Standardaußenabmaß aufweisen, kann die Aufnahme des Bits 15 in der Hexabit-Aufnahme 14 in der Figur 5 dazu verwendet werden, eine Schraube bestimmter Ausbildung, sei es Schlitz, Kreuz, TORX, Inbus, etc. zu lösen oder zu befestigen.

Es wäre auch möglich, in der Bit-Aufnahme ein Zwischenstück anzubringen, welches in der Lage ist, ein Bit zum Lösen oder Festdrehen einer Sechskantschraube, z.B. M3, M4, M5, oder dergleichen, aufzunehmen.

Die Bitaufnahme ist vorzugsweise elektrisch isoliert, auch in der Spannungsprüfeinrichtung, kann aber wie beim bekannten behafteten Spannungsprüfer, auch insoweit elektrisch den Gegenpol bilden, damit bei Berührung der Bitaufnahme durch einen Finger des Bedienpersonals (vergleichbar Fig. 3) auch das in dem Spannungsprüfer untergebrachte Leuchtmittel, z. B. eine Glimmlampe, aufleuchtet, wenn gleichzeitig mit der Spannungsspitze der kontaktbehaftete Leiter berührt wird.

Besonders bevorzugt ist die Ausbildung des erfindungsgemäßen Spannungsgeräts als kontaktloses Spannungsprüfgerät, denn dann ist erstmalig auch eine Werkzeugausbildung möglich, wie sie von bekannten spannungslosen Spannungsprüfgeräten unbekannt ist.

Vorzugsweise ist die Bit-Werkzeug-Aufnahme 14 integraler Bestandteil des Gehäuses des Spannungsprüfers.

Das hat den Vorteil, dass auch beim Lösen bzw. Festziehen einer Schraube relativ große Kräfte aufzubringen sind, ohne dass dabei die Bit-Werkzeug-Aufnahme einen Schaden erleidet.

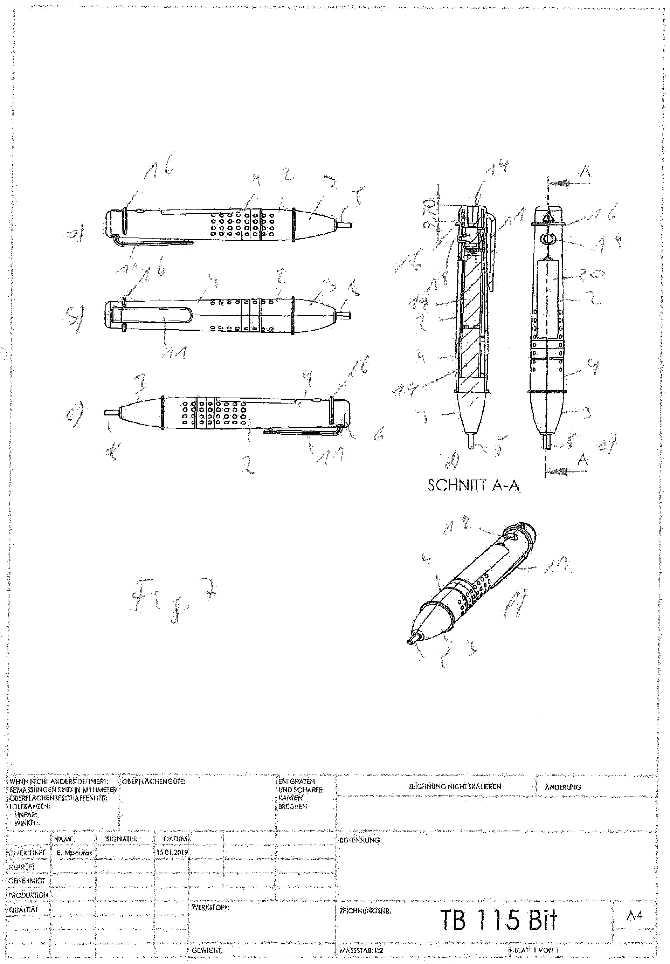

Figur 7 zeigt die erfindungsgemäße Prüfeinrichtung in sechs verschiedenen Darstellungen/Ansichten.

In der Figur 7 ist zu erkennen, dass die erfindungsgemäße Prüfeinrichtung in einem Gehäuseabschnitt 3 in dem vorderen Bereich (mit der Messspitze) und in einem Gehäuseabschnitt 4 in dem hinteren Bereich gebildet ist. Die gesamte Prüfeinrichtung bildet dabei ein längliches Gehäuse und wird wie ein im Prüf- bzw. Werkzeugeinsatz wie ein Stift gehalten.

Im Inneren des Gehäuses der Prüfeinrichtung, die im dargestellten Beispiel wiederum als Spannungsprüfgerät ausgebildet ist, ist eine (bekannte) elektrische Schaltung (nicht dargestellt) untergebracht wie auch eine Aufnahme für Batterien 19, die durch eine verschließbare Klappe 20 an der Längsseite des Gehäuseabschnitts 4 von außen in das Innere einsteckbar sind. Auch weist die erfindungsgemäße Prüfeinrichtung einen Taster (Umschalter) 18 auf, welcher zur Umschaltung zwischen zwei Spannungslevel dient, z.B. zur Umschaltung zwischen dem Spannungslevel 230 und 12 Volt. Ferner weist die Prüfungseinrichtung einen Klipp 11 auf und an der Außenseite, wie beschrieben, die Aufnahme 14 zur Aufnahme eines Standartwerkzeugbits 15, z.B. mit Schraubendreher-Funktion in Form eines Schlitzes oder Kreuzes.

Die Figur 7 zeigt dabei die Prüfeinrichtung ohne eingestecktes Werkzeug.

Ferner ist an der Außenseite nahe am Ende des Gehäuseabschnitts 4, etwa in Höhe des Bodens der Werkzeugaufnahme ein umlaufender Kragen 16 als integraler Bestandteil des Gehäuses ausgebildet. Dieser Kragen 16 bildet eine Fingerbremse, sodass der Benutzer, der ein Werkzeug 15 in die Aufnahme 14 eingelegt hat und dieses benutzt, einen sicheren Halt für seine Hand bzw. seine Finger hat, damit diese nicht über den Kragen 16 hinaus in Richtung des eingesteckten Werkzeugs verrutschen.

Ergänzend oder alternativ zu dieser gezeigten Lösung mit dem Kragen 16 ist es auch möglich, die Außenseite des Gehäuses mit einer strukturierten Oberfläche 17, Fig. 5, die bevorzugt aufgeraut ist, zu versehen um somit ein Verrutschen der Hand bzw. der Finger längs des Gehäuses zu verhindern, wenn ein Werkzeug in die Bitaufnahme eingelegt ist und die Prüfeinrichtung für eine Werkzeugfunktion, z.B. das Festdrehen oder Lösen einer Schraube verwendet wird.

Zur verbesserten Rutschhemmung ist es alternativ oder in Ergänzung zu den vorgeschriebenen Maßnahmen auch möglich, dass der Klipp 11 außenseitig eine raue Oberfläche aufweist (nicht dargestellt), um somit beispielsweise für den Daumen des Benutzers eine maximal mögliche Rutschhemmungsunterlage zu bilden.

Als Stand der Technik wird hingewiesen auf DE 202008001608. Dieses Dokument beschreibt ein Werkzeug mit einem Wechselspannungsdetektor, wobei dieses Werkzeug ähnlich wie ein Stift gehalten wird und ein längliches Gehäuse aufweist, mit einem ersten Ende und einem zweiten Ende. Das erste Ende bildet dabei - anders als die Erfindung der vorliegend beschriebenen Prüfeinrichtung - ein Arbeitsende, in welches ein als Schraubendreher ausgebildetes Bit einführbar ist, und das zweite Ende einen Abschluss bildet, der als Kappe, also von dem Gehäuse lösbares Teil ausgebildet ist, wird diese Kappe gelöst und legt damit den Zugang zu einem Innengehäuse am zweiten Ende vorgesehenen Aufnahmeraum frei, in den das Werkzeug in Form eines Bits einsteckbar ist. Wird das Werkzeug dort in den Aufnahmeraum eingelegt, kann die in dem Dokument beschriebene Aktion eines Wechselspannungsdetektors nicht mehr verifiziert werden, weil dazu die Kappe, wie auch der damit verbundene Wechselspannungsdetektor, aus dem Werkzeug entfernt werden müssen.

Bei der Erfindung der vorliegenden Anmeldung kann aber das Werkzeug in der am zweiten Ende ausgebildeten, außenseitig liegenden Aufnahme eingesteckt werden und gleichzeitig kann auch die erfindungsgemäße Prüfeinrichtung zu Prüfzwecken z.B. zum Messen einer Spannung verwendet werden ohne dabei einen umständliche Umbau vornehmen zu müssen.

### Bezuaszeichen liste

- 1: Prüfeinrichtung
- 2: längliches Gehäuse
- 3: Teil 1
- 4: Teil 2
- 5: erstes Ende
- 6: zweites Ende
- 7: Klinge
- 8: Isolation
- 9: Glimmlampe
- 10: Widerstand
- 11: Metallklipp/Klipp
- 12: metallischer Kontakt
- 13: Gehäuse
- 14: Werkzeug-Aufnahme/Aufnahme
- 15: Standart-Werkzeug-Bit
- 16: Kragen
- 17: strukturierte Oberfläche
- 18: Taster
- 19: Batterie
- 20: Batteriedeckel

## Patentansprüche

1. Prüfeinrichtung (1), welche ähnlich wie ein Stift gehalten wird, wobei die Prüfeinrichtung (1) ein längliches Gehäuse aufweist, mit einem ersten Ende (5) und einem zweiten Ende (6), wobei zur Spannungsprüfung das erste Ende (5) an einen spannungsführenden Leiter gehalten, oder in dessen Nähe gebracht wird und wobei das zweite Ende (6) dem ersten Ende gegenüberliegt und außenseitig eine Aufnahme (14) für ein von außen in die Aufnahme (14) steckbares Werkzeug (15) aufweist, wobei die Aufnahme Standard-Innen-Abmaße für die Aufnahme eines Standart-Werkzeuges aufweist und wobei die Prüfeinrichtung ein Gehäuse aus elektrisch isolierendem Material aufweist.

2. Prüfeinrichtung nach Anspruch 1, **dadurch gekennzeichnet, dass** die Prüfeinrichtung ein kontaktloses oder kontaktbehaftetes Spannungsprüfgerät ist.

3. Prüfeinrichtung nach einem der vorhergehenden Ansprüche, **dadurch gekennzeichnet, dass** die Werkzeug-Aufnahme (14) integraler Bestandteil des Gehäuses (2) der Prüfeinrichtung ist.

4. Prüfeinrichtung nach einem der vorhergehenden Ansprüche, **dadurch gekennzeichnet, dass** die Prüfeinrichtung an dem zweiten Ende (6) einen Klipp (11) aufweist, welcher dazu dient, die Prüfeinrichtung in einem Kleidungsstück, z. B. der Brusttasche eines Hemdes zu fixieren, wobei der Klipp auch dazu ausgebildet ist, bei Benutzung eines Werkzeug-Bits in der Bit-Aufnahme zum lösen/Befestigen einer Schraube oder dergleichen als Angriffspunkt für die Hand des Benutzers zu dienen.

5. Prüfeinrichtung nach einem der vorhergehenden Ansprüche, **dadurch gekennzeichnet, dass** die Prüfeinrichtung im Bereich des zweiten Endes (6) außenseitig an der Längsseite des Gehäuses einen Kragen (16) und/oder eine strukturierte, bevorzugt raue Oberfläche (17) aufweist, wobei der Kragen (16) und/oder die strukturierte Oberfläche (17) als Rutschhemmung für die Hand bzw. Finger des Benutzers dient, wenn dieser die Prüfeinrichtung mit einem in die Aufnahme (14) eingesteckten Werkzeug (15) für eine Werkzeugoperation, z.B. einer Schraubendreher-Funktion, verwendet.
